# EUROPÄISCHE PATENTSCHRIFT

(11) **EP 1 103 049 B1**
(45) Veröffentlichungstag und Bekanntmachung des Hinweises auf die Patenterteilung: **27.08.2003**
(21) Anmeldenummer: 99936412.8
(22) Anmeldetag: 28.05.1999
(51) Int. Cl.: G11C 11/15, G11C 11/56

(54) **MAGNETISCHER SPEICHER**
MAGNETIC MEMORY
MEMOIRE MAGNETIQUE

(30) Priorität: 28.05.1998 DE 19825391
(43) Veröffentlichungstag der Anmeldung: 30.05.2001
(73) Patentinhaber: Hahn-Meitner-Institut Berlin Gesellschaft mit beschränkter Haftung, 14109 Berlin (DE)
(72) Erfinder: NAWRATH, Thorsten, D-24768 Rendsburg (DE); FRITZSCHE, Helmut, D-14057 Berlin (DE); MALETTA, Hansjörg, D-14199 Berlin (DE); NOWIKOW, Jan, D-10437 Berlin (DE)
(74) Vertreter: Hoffmann, Heinz-Dietrich
(86) Internationale Anmeldenummer: DE9901644
(87) Internationale Veröffentlichungsnummer: WO99062068

(56) Entgegenhaltungen:
- EP-A- 0 701 142
- US-A- 5 756 191
- US-A- 5 910 868
- PATENT ABSTRACTS OF JAPAN vol. 1998, no. 09, 31. Juli 1998 (1998-07-31) & JP 10 112562 A (ALPS ELECTRIC CO LTD), 28. April 1998 (1998-04-28)

## Beschreibung

Die Erfindung betrifft einen magnetischen Speicher für binäre Daten wie er bisher beispielsweise als Festplatte oder Wechseldatenträger realisiert worden ist.

Die magnetische Speicherung von binären Daten erfolgt auf dünnen magnetischen Schichten, die ortsabhängig in bestimmte Richtungen aufmagnetisiert werden. Daraus ergibt sich ein Magnetisierungsmuster, dem sich Zahlenkolonnen (Daten) zuordnen lassen. Aufgrund der besonderen Ausbildung des Schreib- bzw. Lesekopfes ist es jedoch nur möglich, Daten in Form von zwei Magnetisierungsrichtungen aufzutragen. Jedem aufmagnetisiertem Bereich wird hierdurch eine Null oder Eins (nein/ja - Information) zugeordnet. Die Speicherdichte des Datenträgers ergibt sich aus der Packungsdichte der einzelnen magnetische Bereiche und ist physikalisch durch die Größe der Koerzitivkraft H_{c} der magnetischen Schicht begrenzt [G. Bate, J. Mag. Mag. Mat. 100, S. 413-424 (1991), W. Zinn Mikromagnetismus dünner Speicherschichten, 21. Band zum JFF Ferienkurs, Jülich (1990)]. Zur Erhöhung der möglichen Speicherdichte ist es erforderlich, die Koerzitivkraft H_{C} der betreffenden magnetischen Schichten zu erhöhen, was bisher nur durch entwicklungstechnisch sehr aufwendige Verfahren möglich war, wobei die Strukturen der magnetischen Schichten variiert wurden. Es mußte hierbei rein empirisch vorgegangen werden, da einmal die Struktur einer magnetischen Schicht auf vielfältige Weise von ihren Herstellungsparametern abhängt und zum anderen keine direkte Beziehung zwischen der Größe der Koerzitivkraft H_{C} und dem strukturellen Aufbau einer magnetischen Schicht besteht [s. C. A. Ross, T. R. Hola, R. Ranjan, D. Lu, J. Appl. Phys. 81,S. 7441-7444 (1997) und R. Ranjan, M. S. Miller, P. K. George, M. Lu, J. Appl. Phys. 69, S. 4727-4729 (1991)]. Ein magnetischer Speicher gemäß dem Oberbegriff des Anspruchs 1 ist ferner aus EP-A-0 718 824 bekannt.

Der Erfindung liegt daher die Aufgabe zugrunde, bei magnetischen Speichern eine vorherbestimmbare Erhöhung der Koerzitivkraft H_{C} in den entsprechenden magnetischen Schichten zu erreichen.

Die Aufgabe wird erfindungsgemäß durch den Gegenstand des Anspruchs 1 gelöst.

Die erfindungsgemäße Lösung beruht auf einem neuen physikalischen Effekt, bei dem die Koerzitivkraft H_{C} einer ferromagnetischen Schicht durch benachbarte Schichten aus antiferromagnetischen Materialien, die eine bestimmte Kristallorientierung aufweisen beeinflußbar ist. Über die Dicke der benachbarten antiferromagnetischen Schicht läßt sich die Koerzitivkraft H_{C} einer ferromagnetischen Schicht gezielt einstellen.

Werden anstelle einer einzelnen ferromagnetischen Schicht mehrere ferromagnetische Schichten vorgesehen, zwischen denen jeweils eine antiferromagnetische Schicht angeordnet ist, wobei die Koerzitivkraft H_{C} in den einzelnen ferromagnetischen Schichten identisch einstellbar ist, ergibt sich eine Erhöhung des magnetischen Signals. Damit erreicht man eine Verbesserung des Signal-Rausch-Verhältnisses. Dabei kann die Dicke der antiferromagnetischen Schichten immer gleichgroß oder jeweils unterschiedlich sein.

In einer weiteren Variante des erfindungsgemäßen magnetischen Speichers weist dieser mehrere ferromagnetische Schichten und zugeordnete antiferromagnetische Schichten bzw. Schichtpakete aus antiferromagnetischen und ferromagnetischen Schichten auf, die jeweils durch unmagnetische Zwischenschichten magnetisch voneinander isoliert sind und deren magnetisches Signal über die Dicke der einzelnen ferromagnetischen Schichten bzw. über die Gesamtdicke des ferromagnetischen Materials in einem Schichtpaket einstellbar ist, wobei die einzelnen Schichtpakete jeweils unterschiedliche Koerzitivfelder aufweisen. Damit ist ein Mehrniveauspeicher realisierbar.

Die Erfindung soll nachstehend an Ausführungsbeispielen anhand der zugehörigen Zeichnung näher erläutert werden.

Es zeigen:
- Fig. 1:: Ein Diagramm, das den Einfluß der Dicke der antiferromagnetischen Schicht auf die Höhe der Koerzitivkraft verdeutlicht,
- Fig. 2 a;b:: Schemata des Schichtaufbaus von erfindungsgemäßen magnetischen Speichern,
- Fig. 3:: ein Schema der Vervielfachung des Schichtaufbaus nach Fig. 2 a,
- Fig. 4:: eine Vervielfachung einzelner Schichtenfolgen für den Aufbau von Mehrniveauspeichern,
- Fig. 5:: Darstellung der Magnetisierung M zweier ferromagnetischer Schichten in Abhängigkeit vom angelegten äußeren Magnetfeld H.

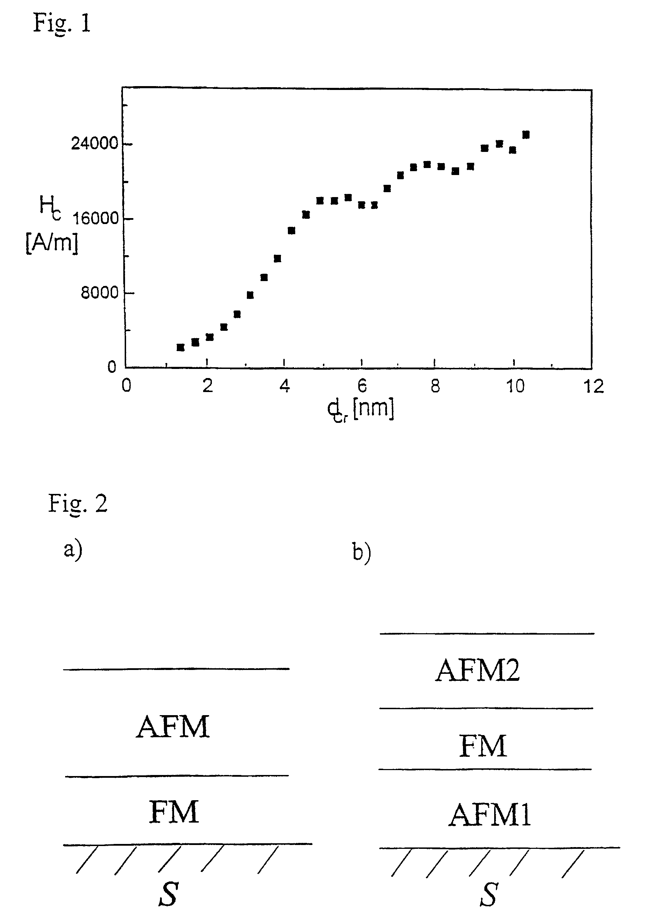

Aus dem Diagramm nach Fig. 1 ist ersichtlich, daß mit zunehmender Dicke der antiferromagnetischen Schicht, die hier beispielsweise aus Chrom besteht, die Koerzitivkraft **H**_{**C**} in der zugehörigen ferromagnetischen Schicht ansteigt. Im Bereich von 2 nm bis 4 nm Dicke der antiferromagnetischen Schicht ergibt sich ein starker linearer Anstieg der Koerzitivkraft **H**_{**C**}. Im Bereich oberhalb von 5 nm ergibt sich ein moderaterer Anstieg in der Koerzitivfeldstärke **H**_{**C**}, der zusätzlich durch Oszillationen von ∼ 3 nm moduliert ist. Diese Oszillationen können sehr vorteilhaft für die Fertigung des Speichers sein, da sich hieraus wiederum Plateaus ergeben, in denen **H**_{**C**} nur noch wenig von der Schichtdicke abhängt. Vorteilhaft sind hierbei die sehr geringen Anforderungen an die Genauigkeit der Chromschichtdicke, deren relativer Wert z.B. im ersten Plateau um ± 20 % variieren darf, um eine Genauigkeit in **H**_{**C**} von ± 3 % einzuhalten. Dies ist ein Vorteil, der hauptsächlich bei der Fertigung großer Speichermedien, zum Tragen kommt.

In Fig. 2a ist der grundlegende Schichtaufbau eines erfindungsgemäßen magnetischen Speichers dargestellt. Auf einem Substrat **S** ist zunächst eine ferromagnetische Schicht **FM** und darauf eine antiferromagnetische Schicht **AFM** aufgebracht. Dies ist produktionstechnisch die einfachste Variante, durch Erhöhung der Schichtdicke der **AFM**-Schicht die Koerzitivkraft **H**_{**C**} in der **FM**-Schicht zu vergrößern. Andererseits läßt sich beispielsweise eine gewünschte Verdopplung der Koerzitivkraft **H**_{**C**} auch durch einen Schichtaufbau gemäß Fig. 2b erreichen. Hier ist auf dem Substrat **S** zunächst eine antiferromagnetische Schicht **AFM**_{**1**} aufgebracht, der die ferromagnetische Schicht **FM** folgt. Darüber liegt eine zweite antiferromagnetische Schicht **AFM**_{**2**}. Die gewünschte Erhöhung der Koerzitivkraft **H**_{**C**} wird dabei auf **AFM**_{**1**} **+ AFM**_{**2**} aufgeteilt, d.h. jede der beiden **AFM**-Schichten muß nur halb so dick sein gegenüber der Erhöhung von **H**_{**C**} auf den gleichen Wert durch nur eine AFM-Schicht. Da nach dem bisherigen Erkenntnisstand eine Sättigung der Koerzitivkraft bei großen **AFM**-Schichtdicken nicht ausgeschlossen werden kann (vgl. Diagramm, Fig. 1), ist dieser Schichtenfolge für die Erreichung sehr großer Koerzitivfelder der Vorzug zu geben.

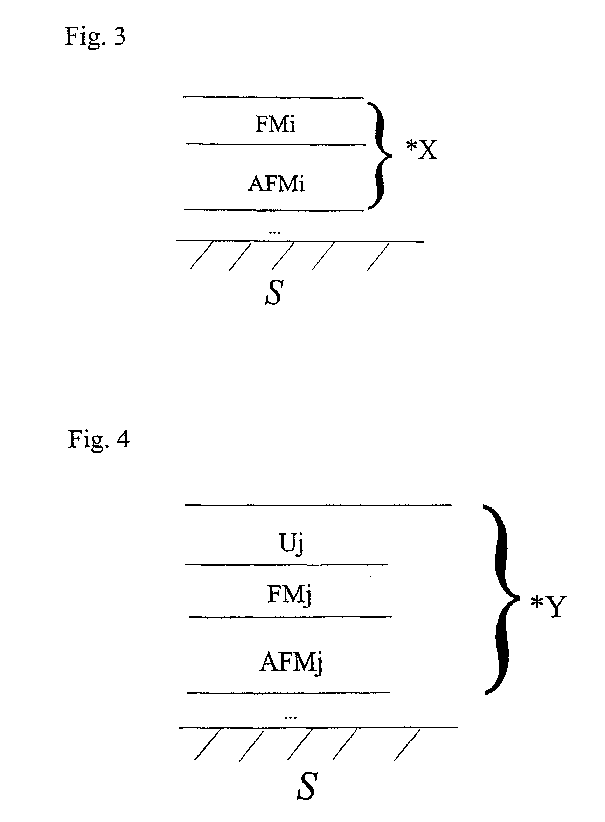

Zur Erhöhung des magnetischen Signals kann man, wie in Fig. 3 dargestellt, den grundlegenden Schichtaufbau vervielfachen. Die antiferromagnetischen Schichten **AFM**_{**i**} sowie die ferromagnetischen Schichten **FM**_{**i**} sind dann X-mal übereinander auf dem Substrat **S** angeordnet. Für die Realisierung eines Mehrniveau-Speichers ist ein Aufbau gemäß Fig. 4 geeignet. Auf einem Substrat **S** sind antiferromagnetische Schichten **AFM**_{**j**}, ferromagnetische Schichten **FM**_{**j**} und unmagnetische Isolierschichten **U**_{**j**} Y-mal übereinander angeordnet. Die Schichtpakete haben jeweils unterschiedliche Koerzitivfelder.

Für die Realisierung einer bestimmten atomaren Struktur der einzelnen Schichten kann es erforderlich sein zwischen dem Substrat **S** und der ersten **AFM**-Schicht eine Übergangsschicht einzubauen. Diese Möglichkeit ist in Fig. 3 und Fig. 4 durch eine Lücke zwischen dem Substrat **S** und der ersten **AFM**-Schicht schon angedeutet. Diese Übergangsschicht ist wichtig für das epitaktische Aufwachsen der einzelnen Schichten. Ihr Material ist abhängig vom verwendeten Substratmaterial. Das Substrat muß elektrisch neutral sein und kann beispielsweise aus **Al**_{**2**}**O**_{**3**}**, Si, MgO** oder **GaAs** bestehen. Weiterhin kann es sinnvoll sein, als oberen Anschluß des gesamten Schichtpakets eine Deckschicht vorzusehen. Diese dient als Oxidationsschutz und Schutz vor mechanischer Beanspruchung.

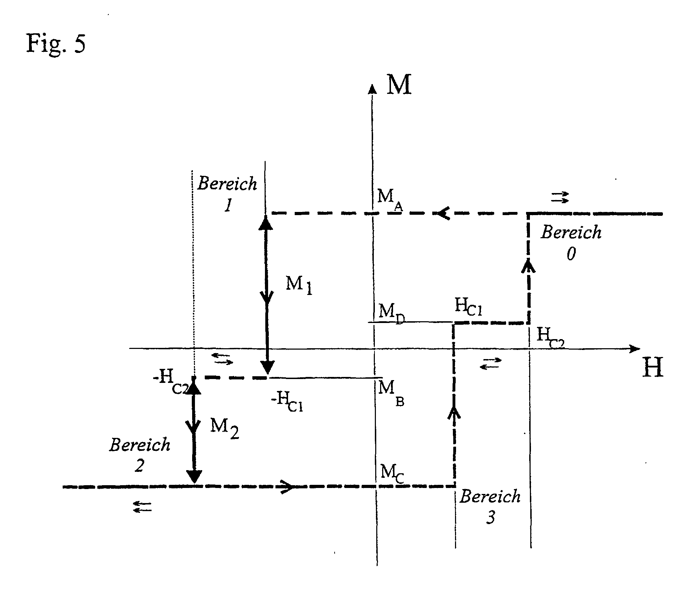

Bringt man auf einem Substrat **N** Schichtpakete mit jeweils verschiedenem **H**_{**C**} und unterschiedlichem magnetischen Signal auf, so ergibt sich daraus die Möglichkeit **2*N** Magnetisierungszustände zu erzeugen und auszulesen. Die Speicherdichte erhöht sich damit um den Faktor **N**. Dieses Verfahren soll am Beispiel von 2 Schichtpaketen dargestellt werden. In Abb. 5 ist hierzu die Magnetisierung **M** der beiden Schichtpakete gegen das äußere Feld **H** aufgetragen. Die Schichtpakete 1 und 2 haben dabei jeweils die Koerzitivfelder **H**_{**C1**} und **H**_{**C2**} und die Magnetisierungen **M**_{**1**} und **M**_{**2**} sind unterschiedlich.
1. Beim Anlegen eines Feldes H>H_{C2} sind beide Schichtpakete in dieselbe Richtung aufmagnetisiert (positiv magnetisiert, Bereich 0): Die Gesamtmagnetisierung ist:
   M_{A}=0.5*(M₁+M₂). Dies sei der Ausgangszustand.
2. Beim Anlegen eines Feldes -H_{C2}<H<H_{C1} (Bereich 1) wird Schichtpaket 1 negativ magnetisiert. Die Gesamtmagnetisierung ist:
   M_{B}=0.5*(-M₁+M₂).
3. Anlegen eines Feldes H<-H_{C2} (Zweig 2) führt zu einer Gesamtmagnetisierung: M_{C}=0.5*(-M₁-M₂)
4. Fährt man das Feld im Bereich 2 in den Bereich 3 mit H_{C1}<H<H_{C2} erhält man als Gesamtmagnetisierung: M_{D}=0.5*(M₁-M₂).
Man erhält also vier verschiedene Magnetisierungszustände M_{A}...M_{D}, im Gegensatz zu zwei bei der herkömmlichen Speichertechnik.

## Patentansprüche

1. Magnetischer Speicher für binäre Daten, mindestens aufweisend eine ferromagnetische Schicht und mindestens eine zu dieser benachbarte antiferromagnetische Schicht, die aus einem aus mehreren atomaren Monolagen bestehenden antiferromagnetischen Material besteht, und eine magnetische Wechselwirkung zwischen der antiferromagnetischen Schicht und der benachbarten ferromagnetischen Schicht (FM2, FMᵢ) besteht
**dadurch gekennzeichnet, daß**
diese antiferromagnetische Schicht eine kubisch raumzentrierte Struktur und eine Kristallorientierung in (110)-Richtung aufweist, wobei die magnetischen Momente in den einzelnen Monolagen in sich antiferromagnetisch ausgerichtet sind und diese antiferromagnetische Schicht (AFM, AFMᵢ, AFMⱼ) eine derartige Dicke aufweist, daß die magnetische Wechselwirkung mit der benachbarten ferromagnetischen Schicht (FM, FMᵢ, FMⱼ), zu einer Erhöhung der Koerzitivkraft (H_{C}) der ferromagnetischen Schicht führt, wobei über die Variation der Dicke der antiferromagnetischen Schicht (AFM, AFMᵢ, AFMⱼ) die Koerzitivkraft (H_{C}) der ferromagnetischen Schicht (FM, FMᵢ, FMⱼ) über einen weiten Bereich gezielt einstellbar ist.

2. Magnetischer Speicher nach Anspruch 1,
**dadurch gekennzeichnet, daß**
zur Erhöhung des magnetischen Signals mehrere ferromagnetische Schichten (FMᵢ) vorgesehen sind, zwischen denen jeweils eine antiferromagnetische Schicht (AFMᵢ) angeordnet ist wobei die Koerzitivkraft (H_{C}), die jeweils über die Dicke der antiferromagnetischen Schichten (AFMᵢ) einstellbar ist, in den einzelnen ferromagnetischen Schichten (FMᵢ) identisch ist.

3. Magnetischer Speicher nach Anspruch 2,
**dadurch gekennzeichnet, daß**
die Dicke der antiferromagnetischen Schichten (AFMᵢ) immer gleich groß ist.

4. Magnetischer Speicher nach Anspruch 2,
**dadurch gekennzeichnet, daß**
die Dicke der antiferromagnetischen Schichten (AFMᵢ) jeweils unterschiedlich ist.

5. Magnetischer Speicher nach Anspruch 1 bis 4,
**dadurch gekennzeichnet, daß**
dieser als Mehrniveauspeicher ausgebildet ist und mehrere ferromagnetische Schichten (FMⱼ) und zugeordnete antiferromagnetische Schichten (AFMⱼ) bzw. Schichtpakete aus antiferromagnetischen und ferromagnetischen Schichten aufweist, die jeweils durch unmagnetische Zwischenschichten (Uⱼ) magnetisch voneinander isoliert sind und deren magnetisches Signal jeweils über die Dicke der einzelnen ferromagnetischen Schicht (FMⱼ) bzw. über die Gesamtdicke des ferromagnetischen Materials in den einzelnen Schichtpaketen einstellbar ist, wobei die einzelnen Schichtpakete jeweils unterschiedliche Koerzitivfelder aufweisen.

6. Magnetischer Speicher nach Anspruch 1,
**dadurch gekennzeichnet, daß**
die Dicke (d) der antiferromagnetischen Schicht (AFM, AFMᵢ) > 2 nm beträgt.

7. Magnetischer Speicher nach Anspruch 1,
**dadurch gekennzeichnet, daß**
die Dicke (d) der antiferromagnetischen Schicht (AFM, AFMᵢ) vorzugsweise in einem Bereich von 2 nm < d < 12 nm liegt.

8. Magnetischer Speicher nach Anspruch 1,
**dadurch gekennzeichnet, daß**
die antiferromagnetische Schicht (AFM, AFMᵢ, AFMⱼ) aus einzelnen Monolagen Chrom mit einer Kristallorientierung in (110)-Richtung besteht.

## Claims

1. Magnetic memory for binary data, having at least one ferromagnetic layer and at least one anti-ferromagnetic layer which is adjacent to it, and which consists of anti-ferromagnetic material which consists of multiple atomic monolayers, and a mutual magnetic effect between the anti-ferromagnetic layer and the adjacent ferromagnetic layer (FM2, FMᵢ) exists,
**characterized in that**
this anti-ferromagnetic layer has a cubically space-centred structure and crystal orientation in the (110) direction, the magnetic moments in the individual monolayers being aligned anti-ferromagnetically in themselves, and this anti-ferromagnetic layer (AFM, AFMᵢ, AFMⱼ) having such a thickness that the mutual magnetic effect with the adjacent ferromagnetic layer (FM, FMᵢ, FMⱼ) results in an increase of the coercive force (H_{c}) of the ferromagnetic layer, it being possible to adjust the coercive force (H_{c}) of the ferromagnetic layer (FM, FMᵢ, FMⱼ) purposefully over a wide range by varying the thickness of the anti-ferromagnetic layer (AFM, AFMᵢ, AFMⱼ).

2. Magnetic memory according to Claim 1,
**characterized in that**
to increase the magnetic signal, multiple ferromagnetic layers (FMᵢ) with an anti-ferromagnetic layer (AFMᵢ) arranged between them in each case are provided, the coercive force (H_{c}), which can be adjusted in each case via the thickness of the anti-ferromagnetic layers (AFMᵢ), being identical in the individual ferromagnetic layers (FMᵢ).

3. Magnetic memory according to Claim 2,
**characterized in that**
the thickness of the anti-ferromagnetic layers (AFMᵢ) is always equal.

4. Magnetic memory according to Claim 2,
**characterized in that**
the thickness of the anti-ferromagnetic layers (AFMᵢ) is different in each case.

5. Magnetic memory according to Claim 1 to 4,
**characterized in that**
this is in the form of a multiple-level memory, and has multiple ferromagnetic layers (FMⱼ) and assigned anti-ferromagnetic layers (AFMⱼ) or layer packages of anti-ferromagnetic and ferromagnetic layers, which are isolated magnetically from each other by non-magnetic layers (Uⱼ), and the magnetic signal of which in each case can be adjusted via the thickness of the ferromagnetic layer (FMⱼ) or via the total thickness of the ferromagnetic material in the individual layer packages, the individual layer packages having different coercive fields in each case.

6. Magnetic memory according to Claim 1,
**characterized in that**
the thickness (d) of the anti-ferromagnetic layer (AFM, AFMᵢ) is > 2 nm.

7. Magnetic memory according to Claim 1,
**characterized in that**
the thickness (d) of the anti-ferromagnetic layer (AFM, AFMᵢ) is preferably in a range from 2 nm < d < 12 nm.

8. Magnetic memory according to Claim 1,
**characterized in that**
the anti-ferromagnetic layer (AFM, AFMᵢ, AFMⱼ) consists of single monolayers of chromium, with a crystal orientation in the (110) direction.

## Revendications

1. Mémoire magnétique pour des données binaires, comportant au moins une couche ferromagnétique et au moins une couche antiferromagnétique voisine de celle-ci, la couche antiferromagnétique se composant d'une matière antiferromagnétique formée de plusieurs monocouches atomiques, avec une interaction existant entre la couche antiferromagnétique et la couche ferromagnétique voisine (FM2, FMᵢ),
**caractérisée en ce que**
cette couche antiferromagnétique présente une structure cubique centrée et une orientation cristallographique (110),
les moments magnétiques des différentes monocouches étant alignés de manière antiferromagnétique et cette couche antiferromagnétique (AFM, AFMᵢ, AFMⱼ) présente une épaisseur telle que l'interaction magnétique avec la couche ferromagnétique voisine (FM, FMᵢ, FMⱼ) conduit à une augmentation de la force coercifive (H_{c}) de la couche ferromagnétique, et par variation de l'épaisseur de la couche antiferromagnétique (AFM, AFMᵢ, AFMⱼ), on règle la force coercitive (H_{c}) ferromagnétique (FM, FMᵢ, FMⱼ) dans une plage étendue.

2. Mémoire magnétique selon la revendication 1,
**caractérisée en ce que**
pour augmenter le signal magnétique, elle comporte plusieurs couches ferromagnétiques (FMᵢ) entre lesquelles il y a chaque fois une couche antiferromagnétique (AFMᵢ) et la force coercitive (H_{c}) qui se règle sur l'épaisseur des couches antiferromagnétiques (AFMᵢ) est identique dans les différentes couches ferromagnétiques (FMᵢ).

3. Mémoire magnétique selon la revendication 2,
**caractérisée en ce que**
l'épaisseur des couches antiferromagnétiques (AFMᵢ) est toujours identique.

4. Mémoire magnétique selon la revendication 2,
**caractérisée en ce que**
l'épaisseur des couches antiferromagnétiques (AFMᵢ) est chaque fois différente.

5. Mémoire magnétique selon l'une quelconque des revendications 1 à 4,
**caractérisée en ce qu'**
elle est réalisée sous la forme d'une mémoire à plusieurs niveaux et comporte plusieurs couches ferromagnétiques (FMⱼ) et des couches antiferromagnétiques (AFMⱼ) associées ou des paquets formés de couches antiferromagnétiques et ferromagnétiques séparées chaque fois de façon magnétique par une couche intermédiaire amagnétique (Uⱼ), et son signal magnétique peut se régler par l'épaisseur des différentes couches ferromagnétiques (FMⱼ) ou suivant l'épaisseur totale de la matière ferromagnétique dans les différents paquets de couches, ces différents paquets de couches ayant chaque fois un champ coercitif différent.

6. Mémoire magnétique selon la revendication 1,
**caractérisée par**
une épaisseur (d) de la couche antiferromagnétique (AFM, AFMᵢ) > 2 nm.

7. Mémoire magnétique selon la revendication 1,
**caractérisée en ce que**
l'épaisseur (d) de la couche antiferromagnétique (AFM, AFMᵢ) est située de préférence dans une plage de 2 nm < d < 12 nm.

8. Mémoire magnétique selon la revendication 1,
**caractérisée en ce que**
la couche antiferromagnétique (AFM, AFMᵢ, AFMⱼ) se compose de plusieurs monocouches de chrome avec une orientation cristallographique (110).
